# EUROPÄISCHE PATENTSCHRIFT

(11) **EP 3 770 357 B1**
(45) Veröffentlichungstag und Bekanntmachung des Hinweises auf die Patenterteilung: **28.12.2022**
(21) Anmeldenummer: 19187919.6
(22) Anmeldetag: 23.07.2019
(51) Int. Cl.: E04D 13/076, E04D 13/10, H02S 40/12, H01L 31/02, B05B 1/20, B05B 1/30, B05B 9/04, B05B 12/08

(54) **GEBÄUDE MIT EINER ENTEISUNGSEINRICHTUNG**
BUILDING WITH A DE-ICING DEVICE
BÂTIMENT AVEC UN DISPOSITIF DE DÉGIVRAGE

(43) Veröffentlichungstag der Anmeldung: 27.01.2021
(73) Patentinhaber: Marcel Boschung AG, 1530 Payerne (CH)
(72) Erfinder: Danisch, Matthias, 90556 Cadolzburg (DE)
(74) Vertreter: Hochreutener, Joel Marc

(56) Entgegenhaltungen:
- EP-A2- 0 125 643
- WO-A2-2004/060568
- DE-B3-102018 201 183
- JP-A- H01 312 178
- JP-A- 2000 257 219
- KR-A- 20130 053 677
- KR-B1- 101 992 157
- US-A- 2 887 073
- US-A- 5 586 837
- US-A1- 2018 078 955
- US-B1- 6 402 052

## Beschreibung

### Gebiet der Erfindung

Die Erfindung betrifft ein Gebäude mit einer Enteisungseinrichtung und ein Verfahren zur Installation einer Enteisungseinrichtung an einem Gebäude.

### Hintergrund

Enteisungseinrichtungen verhindern die Eisbildung auf Dächern von Gebäuden. Auf Fassaden und Dächern mit einer glatten Oberfläche und einer entsprechenden Neigung verhindert das Taumittel, dass der Schnee abrutscht. Eine Enteisungseinrichtung kann auch verhindern, dass bei Schneefällen die zulässige Dachlast überschritten wird, oder dass es zu Schneelawinen kommt.

Enteisungseinrichtungen umfassen eine Pumpe, ein Taumittelreservoir, Sensoren und eine Steuerung, wobei die Steuerung die Enteisungseinrichtung vollautomatisch steuern kann. Die Enteisungseinrichtung kann selbstverständlich auch manuell von einem Benutzer gesteuert werden. Sprühdüsen sprühen das Taumittel auf die Fassaden und Dächer. Die Sensoren ermöglichen eine optimale Dosierung und Besprühung der Oberflächen und damit einen ökonomischen, umweltschonenden Betrieb.

Optimal ist das Taumittel nicht korrosiv und biologisch abbaubar. Es handelt sich beispielsweise um ein Gemisch aus Wasser und Glykol und aus einem geringen Anteil von Zusatzstoffen, um die Wirksamkeit zu verbessern. Solche Taumittel sind auf dem Markt erhältlich. Das Taumittel bildet eine rutschige Oberfläche, sodass sich Eis und Schnee nicht bilden können oder abrutschen.

Ebenfalls bekannt sind Enteisungseinrichtungen mit einem elektrischen Heizsystem, welche einen hohen Energieverbrauch und damit hohe Kosten verursachen.

JP 2000 257219 zeigt eine Wassersprinkler-Anlage zum Schmelzen von Schnee auf einem Dach sowie in der Traufe. Dazu ist ein Rohr mit Auslässen mithilfe von Ständern auf einer Dachrinne befestigt. Dachenteisungseinrichtungen sind ferner aus KR 2013 0053677 und JP H01 312178 bekannt.

### Darstellung der Erfindung

Es ist Aufgabe der vorliegenden Erfindung, ein Gebäude mit einer Enteisungseinrichtung bereitzustellen, welche gegen unterschiedliche Witterungseinflüsse resistent ist und einfach herstellbar und montierbar ist.

Gelöst wird diese Aufgabe durch ein Gebäude Z nach Anspruch 1, mit einer Enteisungseinrichtung zur Aufbringung von Taumittel auf das Gebäude. Die Enteisungseinrichtung weist Sprühaustrittsöffnungen auf, welche derart angeordnet sind, dass Taumittel
- auf das Dach,
- auf eine Dachkante,
- auf eine Schornsteinkante,
- auf eine Dachrinne,
- an eine Fassade,
- auf eine Solarzelle des Gebäudes, und/oder
- auf eine Parabolantenne eines Gebäudes gesprüht wird.

Die Enteisungseinrichtung umfasst ein erstes Hohlprofil (4). Diesem wird das Taumittel über eine Zufuhrleitung (3) zugeführt. Die Zufuhrleitung (3) ist ein zweites Hohlprofil, wobei das erste und/oder das zweite Hohlprofil ein hohles Bauprofil (9a) des Gebäudes (1) ist.

Insbesondere sprüht die Enteisungseinrichtung das Sprühmittel direkt auf die genannten Oberflächen. Dies bedeutet, dass das aus den Sprühaustrittsöffnungen strömende Taumittel direkt auf die genannten Oberflächen gelangt, und das Taumittel nicht zuerst entlang von Oberflächen des Gebäudes strömen muss, um zu den gewünschten Oberflächen zu gelangen.

Vorteilhaft sind die Sprühaustrittsöffnungen innerhalb der Dachrinne angeordnet. Diese Anordnung verhindert die Eisbildung innerhalb der Dachrinnen und die Bildung von Eiszapfen an den Dachrinnen. Dies erhöht die Sicherheit durch Vermeidung herunterfallender Eiszapfen. Die Freihaltung der Dachrinnen erlaubt das ungehinderte Abfliessen von schmelzendem Schnee.

In einer besonderen Ausführungsform verlaufen das erste und/oder das zweite Hohlprofil entlang einer Wandkante, entlang einer Dachkante, entlang eines Gibels, entlang eines Firsts, entlang einer Traufe, entlang eines Grats, entlang einer Kehle und/oder entlang einer Ablaufrinne. Eine gut bedachte Anordnung der Hohlprofile ermöglicht es, die Enteisungseinrichtung möglichst kostengünstig auszugestalten.

Das zweite Hohlprofil ist insbesondere eine Laststütze oder ein Türrahmen. Mit anderen Worten kann das Taumittel den Sprühaustrittsöffnungen durch Standardbauprofile eines Hauses zugeführt werden. Das Taumittel strömt beispielsweise durch Laststützen hindurch, sodass keine speziellen Zufuhrleitungen montiert werden müssen, welche die Ästhetik des Gebäudes negativ beeinflussen könnten. Die Enteisungseinrichtung wird somit an die Architektur des Gebäudes angepasst. Ausserdem können Zufuhrleitungen eingespart werden.

Vorteilhaft ist das erste Hohlprofil an der Innenseite eines hohlen Bauprofils des Gebäudes, insbesondere an der Innenseite eines Fensterrahmens, angeordnet, und insbesondere weist das hohle Bauprofil Bauprofilöffnungen, insbesondere Löcher im Fensterrahmen, auf, welche derart angeordnet sind, dass das Taumittel aus den Sprühaustrittsöffnungen durch die Bauprofilöffnungen nach aussen strömt.

Die Durchführung von Taumittel durch Bauprofile des Gebäudes ist nicht nur bei einem Neubau möglich, sondern insbesondere auch bei einer nachträglichen Installation der Enteisungseinrichtung an einem bestehenden Gebäude.

Ein Hohlprofil ist ein Rohr mit einem beliebigen Querschnitt, wobei das Taumittel durch das Hohlprofil strömen kann. Im Gegensatz zu einem Gummischlauch ist ein Hohlprofil ein verhältnismässig robustes Beförderungsmittel. Ein Hohlprofil weist eine steife Geometrie auf, sodass das Hohlprofil nicht wie bei einem Gummischlauch aufgrund seines Eigengewichts zwischen zwei Tragstützen durchhängt. Durch seinen robusten Aufbau ist das Hohlprofil auch genügend solide, um ungünstigen Witterungsbedingungen, wie starker Schneefall, Sturm etc., zu widerstehen.

Vorteilhaft umfasst das erste Hohlprofil eine Zufuhröffnung, durch welche das Taumittel in das Hohlprofil einströmen kann. Ein Rückschlagventil ist in der Zufuhröffnung angeordnet.

Das Rückschlagventil verhindert, dass das Taumittel entgegen der üblichen Strömungsrichtung aus dem Hohlprofil zurückströmen kann. Dadurch lässt sich die Befüllung des Hohlprofils besser kontrollieren. Das Hohlprofil wird auch nicht entleert, falls im System ein Leck vorhanden ist oder die Pumpe abschaltet.

Im Weiteren kann das Hohlprofil mindestens drei Sprühaustrittsöffnungen umfassen. Das Taumittel strömt durch die Sprühaustrittsöffnungen aus dem Hohlprofil und gelangt dadurch auf die zu besprühende Oberfläche. Die Anordnung mehrerer Sprühaustrittsöffnungen in einem Hohlprofil ermöglicht eine stabile Ausgestaltung der Enteisungseinrichtung auf Dächern. Ausserdem lassen sich Hohlprofile mit mehreren Sprühaustrittsöffnungen einfacher herstellen, wie wenn sämtliche Sprühköpfe mittels eines Schlauchs verbunden werden müssen.

"Sprühen" ist breit zu verstehen. Es umfasst insbesondere die Benetzung der Oberfläche mittels eines Sprühnebels und/oder mittels Beträufeln. Ein Beträufeln ist insbesondere dann vorgesehen, wenn Wind den Sprühnebel verwehen würde.

Insbesondere ist die Steuerung der Enteisungseinrichtung derart ausgestaltet, dass in Abhängigkeit der Windverhältnisse durch Steuerung des Pumpendrucks ein Sprühnebel oder ein Beträufeln erzeugt wird.

Denn wird der Pumpendruck niedrig eingestellt, träufeln lediglich Tropfen durch die Sprühaustrittsöffnungen, während sich bei einem hohen Druck ein Sprühnebel bildet.

Insbesondere sind an den mindestens zwei Sprühaustrittsöffnungen Rückschlagventile angeordnet. Dies verhindert, dass Schnee- oder Regenwasser oder Schmutz in das Hohlprofil hineinströmt.

In einer besonderen Ausführungsform ist mindestens eine Düse an den mindestens zwei Sprühaustrittsöffnungen angeordnet. Insbesondere ist die Düse derart ausgestaltet, dass das Taumittel nur bei einem Taumitteldruck grösser als 1.5 bar, insbesondere grösser als 2 bar, insbesondere grösser als 3 bar, insbesondere grösser als 5 bar, aus dem ersten Hohlprofil austritt. Alternativ sind die Sprühaustrittsöffnungen einfache Bohrungen ohne Düsen.

Die Düsen verhindern, dass das im Hohlprofil vorhandene Taumittel bei Erwärmung, beispielsweise aufgrund von Sonneneinstrahlung, und der daraus folgenden Ausdehnung nicht durch die Sprühaustrittsöffnungen aus dem Hohlprofil austritt. Ist das Hohlprofil nicht waagrecht angeordnet oder sind die Sprühaustrittsöffnungen in Richtung der Schwerkraft ausgerichtet, so verhindern die Düsen, dass das Taumittel aufgrund der Schwerkraft aus dem Hohlprofil austritt.

Erfindungsgemäß führt eine Zufuhrleitung das Taumittel dem Hohlprofil zu. Die Zufuhrleitung ist ein zweites Hohlprofil und umfasst keine Sprühaustrittsöffnungen.

Insbesondere ist ein Rückschlagventil in der Zufuhrleitung angeordnet. Diese Anordnung verhindert, dass bei einem Leck sich das System nicht vollständig entleert, sondern Taumittel nur Abschnittsweise verloren geht. Das Rückschlagventil in der Zufuhrleitung ermöglicht somit einen sicheren und zuverlässigen Betrieb der Enteisungseinrichtung.

In einer besonderen Ausführungsform sind das erste und/oder das zweite Hohlprofil aus einem Material mit einem E-Modul grösser als 100 MPa, insbesondere grösser als 500 MPa, insbesondere grösser als 1GPa. Insbesondere ist das Material Aluminium oder ein Kunststoff. Solche Enteisungseinrichtungen sind stabil und resistent gegen verschiedenste Witterungseinflüsse.

Vorteilhaft sind das erste und/oder das zweite Hohlprofil ein Rundprofil, ein eckiges Profil, insbesondere ein rechteckiges, quadratisches oder dreieckiges Profil.

### Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:
Fig. 1 ein erstes Gebäude mit einer auf dem Dach angeordneten Enteisungseinrichtung;
Fig. 2 ein zweites Gebäude mit einer auf dem Dach angeordneten Enteisungseinrichtung;
Fig. 3 ein Hohlprofil mit drei Sprühaustrittsöffnungen;
Fig. 4 eine Schnittansicht durch das Hohlprofil gemäss Fig. 3;
Fig. 5 eine Schnittansicht durch zwei erste Hohlprofile, welche mittels eines Schlauchs zusammengehängt sind;
Fig. 6 eine Schnittansicht durch den Querschnitt des Hohlprofils;
Fig. 7a eine Schnittansicht eines Fensterrahmens einer Fassade mit einem integrierten Hohlprofil; und
Fig. 7b eine Schnittansicht eines Fensterrahmens einer Fassade mit einem aufgeklemmten Hohlprofil.

### Wege zur Ausführung der Erfindung

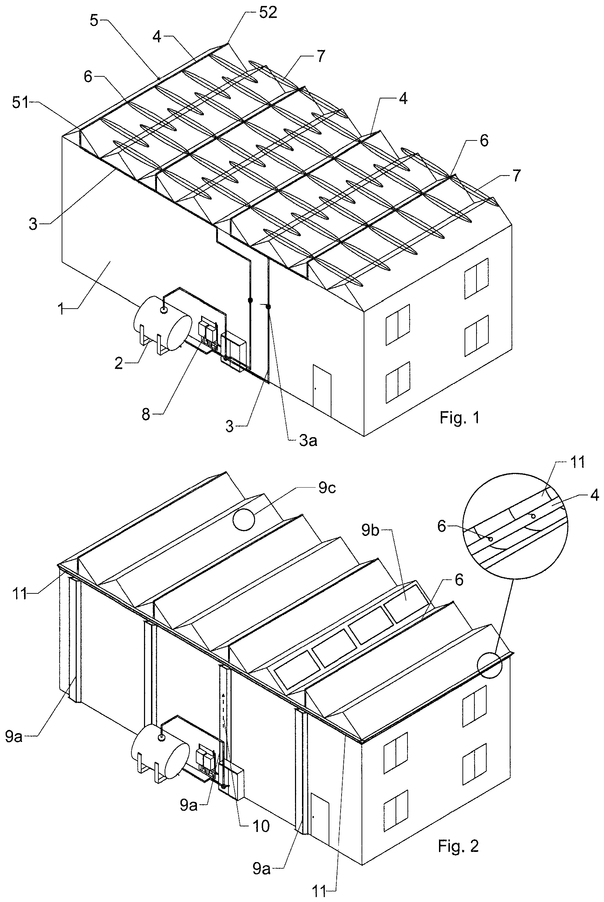

Die Fig. 1 zeigt ein erstes Fabrikgebäude 1 mit einer Enteisungseinrichtung. Diese umfasst ein Taumittelreservoir 2, in welcher das Taumittel in einer grossen Menge bevorratet ist. Eine Pumpe befördert das Taumittel aus dem Taumittelreservoir 2 über Zufuhrleitungen 3 zu auf dem Dach angeordneten ersten Hohlprofilen 4. Die Zufuhrleitungen 3 können sowohl Schläuche als auch zweite Hohlprofile sein und Rückschlagventile 3a umfassen.

Ein Tankfahrzeug kann das Taumittelreservoir 2 mit Taumittel befüllen. Ein Taumittelreservoir umfasst beispielsweise 30'000 Liter. Die Pumpe kann mit einem Druck von 16 bar fördern.

Die Hohlprofile 4 sind auf den Dachkanten 5 des Gebäudes angeordnet. Jedes Hohlprofil umfasst jeweils fünf oder sechs Sprühaustrittsöffnungen 6. Das Hohlprofil reicht jeweils von einem ersten Ende 51 zu einem zweiten Ende 52 der Dachkanten 5 und erstreckt sich damit über die gesamte Länge der jeweiligen Dachkante 5 hinweg. Weiter dargestellt ist der Sprühnebel 7, welcher aus den Sprühaustrittsöffnungen 6 austritt und auf die benachbarten Dachflächen gelangt. Eine Steuerung 8 steuert die Enteisungseinrichtung.

Die Versprühung von Taumittel auf dem Dach des Gebäudes verhindert die Bildung von Eisflächen und das Abrutschen von Schnee. Ebenso verhindert es das Überschreiten der zulässigen Dachlast oder die Bedeckung von Solarzellen oder Parabolantennen mit Schnee. Der Sprühnebel 7 ist ein Aerosol, welches für das normale Auge unsichtbar ist.

Spezielle Sensoren (nicht gezeigt) steuern einen vollautomatischen Betrieb der Anlage und sorgen für eine bedarfsgerechte Dosierung und Besprühung der Oberflächen.

Die Fig. 2 zeigt ein zweites Fabrikgebäude mit einer Enteisungseinrichtung. Zur besseren Übersicht wurde auf die Darstellung des Sprühnebels verzichtet. An der Fassade des Gebäudes sind hohle Laststützen 9a angeordnet, welche das Dach des Gebäudes stützen. Bei der vorliegenden Installation dient eine der Laststützen 9a als Zufuhrleitung, um das Taumittel vom Taumittelreservoir 2 zu den Sprühaustrittsöffnungen 6 auf das Dach zu befördern. Die Strömungsrichtung des Taumittels ausgehend vom Taumittelreservoir 2 durch diese eine Laststütze 9a ist mit dem Pfeil 10 dargestellt. Durch die Verwendung der Laststütze 9a als Zufuhrleitung erscheint die Enteisungseinrichtung am Gebäude unauffälliger.

Im Weiteren sind auf dem Dach Solarzellen 9b und eine Parabolantenne 9c angeordnet. Damit diese stets frei von Schnee sind und damit die Solarzellen Sonnenlicht absorbieren können, sind die Sprühaustrittsöffnungen 6 derart angeordnet, dass das Taumittel direkt auf die Solarzellen 9b und die Parabolantenne 9c gesprüht wird.

An der Oberseite der Fassade sind Dachrinnen 11 angeordnet, welche das von den Dächern herabfliessende Wasser auffangen und einem Fallrohr zuführen, damit das Wasser in die Kanalisation abfliessen kann. Innerhalb der Dachrinnen 11 sind Hohlprofile 4 mit Sprühaustrittsöffnungen 6 angeordnet. Diese Anordnung verhindert die Eisbildung innerhalb der Dachrinnen 11 und die Bildung von Eiszapfen an den Dachrinnen 11. Das Abfliessen von Tauwasser ist damit gewährleistet und Unfälle aufgrund herabfallender Eiszapfen können vermieden werden.

In Abhängigkeit der herrschenden Temperaturen und in Abhängigkeit der Witterungsbedingungen wird die Enteisungseinrichtung beispielsweise während 1 bis 5 Minuten durchgehend betrieben. Bei geringerem Niederschlag kann es aber auch schon ausreichend sein, die Enteisungseinrichtung jeweils nach 5 Minuten Pause während 10 Sekunden zu betreiben.

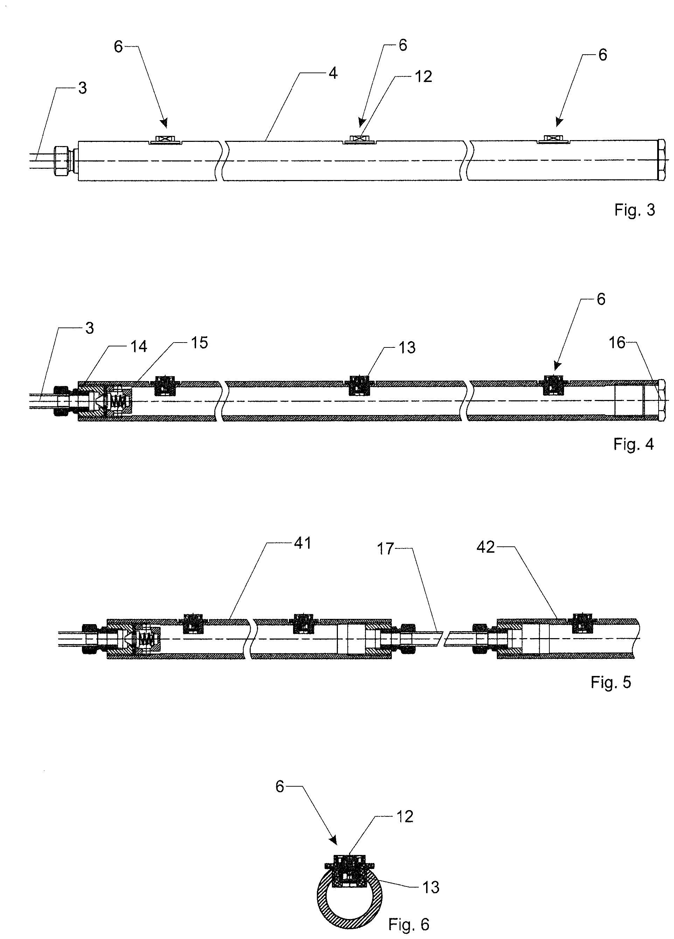

Die Fig. 3 zeigt ein erstes Hohlprofil 4 mit Sprühaustrittsöffnungen 6. Die Fig. 4 zeigt eine Schnittansicht des in Fig. 3 gezeigten Hohlprofils 4. Die Sprühaustrittsöffnungen 6 umfassen Düsen 12 und Rückschlagventile 13. Die Düsen 12 stellen sicher, dass das im Hohlprofil vorhandene Taumittel bei Erwärmung, beispielsweise aufgrund von Sonneneinstrahlung, und der daraus folgenden Ausdehnung nicht durch die Sprühaustrittsöffnungen aus dem Hohlprofil 4 austritt. Weiter verhindern die Düsen 12 auch, dass Taumittel aufgrund der Schwerkraft aus dem Hohlprofil 4 austritt. Ein Austritt von Taumittel durch die Sprühaustrittsöffnungen 6 ist somit nur dann möglich, wenn die Pumpe der Enteisungseinrichtung aktiviert ist.

Die an den Sprühaustrittsöffnungen 6 angeordneten Rückschlagventile 13 verhindern, dass Schnee- bzw. Regenwasser oder Schmutz von aussen in die Hohlprofile 4 hineinströmt. Der Wartungsaufwand der Enteisungseinrichtung kann dadurch reduziert werden.

Beim Hohlprofil 4 handelt es sich in der vorliegenden Ausführungsform um ein rundes, hohles Rohr, welches bevorzugt aus Aluminium oder einem starken Kunststoff, beispielsweise POM, gefertigt ist. Aufgrund der Materialsteifigkeit verläuft das Hohlprofil 4 gerade und es entsteht kein Durchhängen zwischen den Tragstützen, wie es bei Gummischläuchen der Fall wäre.

Das Taumittel wird den Hohlprofilen 4 über Zufuhrleitungen 3 zugeführt. Das Taumittel strömt an der Zufuhröffnung 14 in das Hohlprofil 4, wobei in der Zufuhröffnung 14 ein Rückschlagventil 15 angeordnet ist. Das Rückschlagventil 15 verhindert, dass im Hohlprofil 4 vorhandenes Taumittel zurück in die Zufuhrleitung 3 strömt. Damit soll sichergestellt werden, dass stets Taumittel in den Hohlprofilen 4 vorhanden ist.

Auf der gegenüberliegenden Seite ist das Hohlprofil 4 mit einem Verschluss 16 verschlossen.

In der Fig. 4 sind zwei erste Hohlprofile 41 und 42 gezeigt, welche mittels einer Verbindungsleitung 17, vorliegend mit einem Schlauch miteinander verbunden sind. Mit dem Schlauch können die voneinander entfernten Hohlprofile 41 und 42 kostengünstig miteinander verbunden werden.

Die Fig. 6 zeigt einen Schnitt durch ein erstes Hohlprofil 4 an derjenigen Stelle, an welcher eine Sprühaustrittsöffnung 6 angeordnet ist.

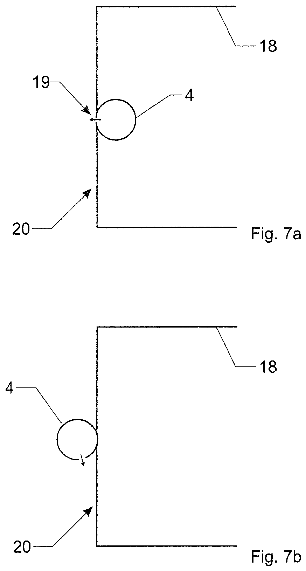

Die Fig. 7a und 7b zeigen eine vertikale Fassade mit einem hohlen Bauprofil, welches beispielsweise ein Fensterrahmen 18 ist. Die Fig. 7a zeigt eine Ausführungsform, bei welcher das erste Hohlprofil 4 an der Innenseite des Fensterrahmens 18 angeordnet ist. Beim Berührungspunkt zwischen Fensterrahmen 18 und dem ersten Hohlprofil 4 sind Löcher 19 im Fensterrahmen angeordnet, durch welche das Taumittel aus dem ersten Hohlprofil 4 in Pfeilrichtung nach aussen strömt. Bei dieser Ausführungsform ist das erste Hohlprofil diskret innerhalb des Fensterrahmens angeordnet, sodass die Enteisungseinrichtung an der Fassade von aussen kaum oder gar nicht wahrnehmbar ist.

Die Fig. 7b zeigt eine Ausführungsform, bei welcher das erste Hohlprofil 4 auf den Fensterrahmen aufgeklemmt, beispielsweise aufgeschraubt, ist. Diese Ausführungsform ist vor allem dann interessant, wenn die Enteisungseinrichtung nachträglich eingebaut wird.

In den Fig. 7a und 7b besprüht die Enteisungseinrichtung jeweils die unterhalb des ersten Hohlprofils 4 angeordnete Fassadenoberfläche 20.

## Patentansprüche

1. Gebäude (1) mit einer Enteisungseinrichtung zur Aufbringung von Taumittel auf das Gebäude (1),
wobei die Enteisungseinrichtung Sprühaustrittsöffnungen (6) aufweist, welche derart angeordnet sind, dass Taumittel, insbesondere direkt,
- auf das Dach,
- auf eine Dachkante,
- auf eine Schornsteinkante,
- auf eine Dachrinne (11),
- an eine Fassade,
- auf eine Solarzelle (9b) des Gebäudes, und/oder
- auf eine Parabolantenne (9c) eines Gebäudes gesprüht wird,
wobei die Enteisungseinrichtung ein erstes Hohlprofil (4) umfasst,
wobei dem ersten Hohlprofil (4) das Taumittel über eine Zufuhrleitung (3) zugeführt wird,
wobei die Zufuhrleitung (3) ein zweites Hohlprofil ist,
**gekennzeichnet dadurch, dass**
das erste und/oder zweite Hohlprofil ein hohles Bauprofil (9a) des Gebäudes (1) ist.

2. Gebäude nach Anspruch 1, wobei die Sprühaustrittsöffnungen (6) innerhalb der Dachrinne (11) angeordnet sind.

3. Gebäude nach einem der vorangehenden Ansprüche, wobei das erste (4) und/oder das zweite Hohlprofil entlang einer Wandkante, entlang einer Dachkante (5), entlang eines Gibels, entlang eines Firsts, entlang einer Traufe, entlang eines Grats, entlang einer Kehle und/oder entlang einer Ablaufrinne (11) verlaufen.

4. Gebäude nach einem der vorangehenden Ansprüche, wobei das hohle Bauprofil (9a) eine Laststütze oder ein Türrahmen ist.

5. Gebäude nach einem der vorangehenden Ansprüche, wobei das erste Hohlprofil (4) eine Zufuhröffnung (14) aufweist, in welcher ein Rückschlagventil (15) angeordnet ist.

6. Gebäude nach einem der vorangehenden Ansprüche, wobei das erste Hohlprofil (4) mindestens zwei, insbesondere mindestens drei, Sprühaustrittsöffnungen (6) umfasst,
insbesondere wobei an den mindestens zwei Sprühaustrittsöffnungen (6) Rückschlagventile (13) angeordnet sind.

7. Gebäude nach Anspruch 6, wobei die mindestens zwei Sprühaustrittsöffnungen (6) mindestens eine Düse (12) umfassen, insbesondere wobei die Düse (12) derart ausgestaltet ist, dass das Taumittel nur bei einem Taumitteldruck grösser als 1.5 bar, insbesondere grösser als 2 bar, insbesondere grösser als 3 bar, insbesondere grösser als 5 bar, aus dem ersten Hohlprofil (4) austritt, oder
wobei die mindestens zwei Sprühaustrittsöffnungen (4) Bohrungen sind.

8. Gebäude nach Anspruch 7, wobei in der Zufuhrleitung (3) ein Rückschlagventil (3a) angeordnet ist.

9. Gebäude nach einem der vorangehenden Ansprüche, wobei das erste (4) und/oder das zweite Hohlprofil aus einem Material mit einem E-Modul grösser als 100 MPa, insbesondere grösser als 500 MPa, insbesondere grösser als 1GPa, besteht,
insbesondere wobei das Material Aluminium, oder ein Kunststoff ist.

10. Gebäude nach einem der vorangehenden Ansprüche, wobei das erste (4) und/oder zweite Hohlprofil ein Rundprofil, ein eckiges Profil, insbesondere ein rechteckiges, quadratisches oder dreieckiges Profil ist.

11. Verfahren zur nachträglichen Installation der Enteisungseinrichtung an einem bestehenden Gebäude (1) nach einem der vorangehenden Ansprüche, wobei das zweite Hohlprofil ein hohles Bauprofil (9a) des Gebäudes ist, insbesondere eine Laststütze oder ein Türrahmen.

## Claims

1. Building (1) with a de-icing device for applying de-icing agent to the building (1),
the de-icing device having spray outlet openings (6) which are arranged in such a way that de-icing agent can be applied, in particular directly,
- onto the roof,
- onto a roof edge,
- onto a chimney edge,
- onto a gutter (11),
- on a facade,
- on a solar cell (9b) of the building,
and/or
- on a parabolic antenna (9c) of a building,
or
sprayed,
wherein the de-icing device comprises a first hollow profile (4),
wherein the de-icing agent is supplied to the first hollow profile (4) via a supply line (3),
wherein the supply line (3) is a second hollow profile, **characterised in that**
the first and/or second hollow profile is a hollow structural profile (9a) of the building (1).

2. Building according to claim 1, wherein the spray outlet openings (6) are arranged inside the gutter (11) .

3. Building according to any one of the preceding claims, wherein the first (4) and/or the second hollow profile extend along a wall edge, along a roof edge (5), along a gable, along a ridge, along an eaves, along a ridge, along a valley and/or along a gutter (11).

4. Building according to any one of the preceding claims, wherein the hollow structural profile (9a) is a load support or a door frame.

5. Building according to any one of the preceding claims, wherein the first hollow profile (4) comprises a supply opening (14) in which a non-return valve (15) is arranged.

6. Building according to any one of the preceding claims, wherein the first hollow profile (4) comprises at least two, in particular at least three, spray outlet openings (6),
in particular wherein non-return valves (13) are arranged at the at least two spray outlet openings (6) .

7. Building according to claim 6, wherein the at least two spray outlet openings (6) comprise at least one nozzle (12), in particular wherein the nozzle (12) is designed in such a way that the de-icing agent only emerges from the first hollow profile (4) at a de-icing agent pressure greater than 1.5 bar, in particular greater than 2 bar, in particular greater than 3 bar, in particular greater than 5 bar, or
wherein the at least two spray outlet openings (4) are bores.

8. Building according to claim 7, wherein a non-return valve (3a) is arranged in the supply line (3).

9. Building according to one of the preceding claims, wherein the first (4) and/or the second hollow profile consists of a material with a modulus of elasticity greater than 100 MPa, in particular greater than 500 MPa, in particular greater than 1GPa,
in particular wherein the material is aluminium or a plastic.

10. Building according to one of the preceding claims, wherein the first (4) and/or second hollow profile is a round profile, an angular profile, in particular a rectangular, square or triangular profile.

11. Method for retrofitting the de-icing device to an existing building (1) according to any one of the preceding claims, wherein the second hollow profile is a hollow structural profile (9a) of the building, in particular a load support or a door frame.

## Revendications

1. Bâtiment (1) avec un dispositif de dégivrage pour appliquer un agent de dégivrage sur le bâtiment (1),
le dispositif de dégivrage présentant des ouvertures de sortie de pulvérisation (6) qui sont disposées de telle sorte que l'agent de dégivrage peut être appliqué, en particulier directement,
- sur le toit
- sur un bord de toit,
- sur un bord de cheminée
- sur une gouttière (11),
- sur une façade,
- sur une cellule solaire (9b) du bâtiment, et/ou
- sur une antenne parabolique (9c) du bâtiment, ou bien
pulvérisé,
dans lequel le dispositif de dégivrage comprend un premier profilé creux (4),
dans lequel l'agent de dégivrage est fourni au premier profilé creux (4) via une ligne d'alimentation (3),
dans lequel la ligne d'alimentation (3) est un second profilé creux, **caractérisé en ce que**
le premier et/ou le second profilé creux est un profilé structurel creux (9a) du bâtiment (1).

2. Bâtiment selon la revendication 1, dans lequel les ouvertures de sortie de pulvérisation (6) sont disposées à l'intérieur de la gouttière (11).

3. Bâtiment selon l'une des revendications précédentes, dans lequel le premier (4) et/ou le second profilé creux s'étendent le long d'un bord de mur, le long d'un bord de toit (5), le long d'un pignon, le long d'un faîte, le long d'un avant-toit, le long d'un faîtière, le long d'une noue et/ou le long d'une gouttière (11).

4. Bâtiment selon l'une des revendications précédentes, dans lequel le profilé structurel creux (9a) est un support de charge ou un encadrement de porte.

5. Bâtiment selon l'une des revendications précédentes, dans lequel le premier profilé creux (4) comprend une ouverture d'alimentation (14) dans laquelle est disposé un clapet anti-retour (15).

6. Bâtiment selon l'une des revendications précédentes, dans lequel le premier profilé creux (4) comprend au moins deux, en particulier au moins trois, ouvertures de sortie de pulvérisation (6),
en particulier dans lequel des clapets anti-retour (13) sont disposés au niveau des au moins deux ouvertures de sortie de pulvérisation (6).

7. Bâtiment selon la revendication 6, dans lequel les au moins deux ouvertures de sortie de pulvérisation (6) comprennent au moins une buse (12), en particulier dans lequel la buse (12) est conçue de telle sorte que l'agent de dégivrage ne sort du premier profilé creux (4) que pour une pression d'agent de dégivrage supérieure à 1,5 bar, en particulier supérieure à 2 bar, en particulier supérieure à 3 bar, en particulier supérieure à 5 bar, ou
dans lequel les au moins deux ouvertures de sortie de pulvérisation (4) sont des alésages.

8. Bâtiment selon la revendication 7, dans lequel un clapet anti-retour (3a) est disposé dans la conduite d'alimentation (3).

9. Bâtiment selon l'une des revendications précédentes, dans lequel le premier (4) et/ou le second profilé creux est constitué d'un matériau présentant un module d'élasticité supérieur à 100 MPa, notamment supérieur à 500 MPa, en particulier supérieur à 1GPa,
en particulier dans lequel le matériau est de l'aluminium ou une matière plastique.

10. Bâtiment selon l'une des revendications précédentes, dans lequel le premier (4) et/ou le second profilé creux est un profilé rond, un profilé angulaire, en particulier un profilé rectangulaire, carré ou triangulaire.

11. Procédé de mise en conformité du dispositif de dégivrage sur un bâtiment (1) existant selon l'une des revendications précédentes, dans lequel le deuxième profilé creux est un profilé structurel creux (9a) du bâtiment, notamment un support de charge ou un encadrement de porte.
